(19) Europäisches Patentamt
European Patent Office
Office européen des brevets

(11) **EP 0 992 114 B1**

(12) **EUROPÄISCHE PATENTSCHRIFT**

(45) Veröffentlichungstag und Bekanntmachung des Hinweises auf die Patenterteilung:
**24.10.2001 Patentblatt 2001/43**

(21) Anmeldenummer: **98934840.4**

(22) Anmeldetag: **02.06.1998**

(51) Int Cl.⁷: $H03K\ 17/06$, $H03K\ 17/042$

(86) Internationale Anmeldenummer:
**PCT/DE98/01490**

(87) Internationale Veröffentlichungsnummer:
**WO 99/01938 (14.01.1999 Gazette 1999/02)**

(54) **ANSTEUERSCHALTUNG FÜR EIN STEUERBARES HALBLEITERBAUELEMENT**

CONTROL CIRCUIT FOR A CONTROLLABLE SEMICONDUCTOR COMPONENT

CIRCUIT DE COMMANDE POUR COMPOSANT SEMI-CONDUCTEUR REGLABLE

(84) Benannte Vertragsstaaten:
**AT DE FR GB IE IT**

(30) Priorität: **02.07.1997 DE 19728283**

(43) Veröffentlichungstag der Anmeldung:
**12.04.2000 Patentblatt 2000/15**

(73) Patentinhaber: **Infineon Technologies AG
81669 München (DE)**

(72) Erfinder: **XU, Chihao
D-81249 München (DE)**

(74) Vertreter: **Bickel, Michael
Westphal - Mussgnug & Partner
Patentanwälte
Mozartstrasse 8
80336 München (DE)**

(56) Entgegenhaltungen:
**EP-A- 0 405 407          EP-A- 0 572 706
DE-A- 3 314 300          DE-A- 3 405 936
DE-A- 4 403 201          GB-A- 2 180 422
GB-A- 2 288 091**

**Beschreibung**

Die vorliegende Erfindung betrifft eine Ansteuerschaltung für ein steuerbares Halbleiterbauelement, und insbesondere eine Ansteuerschaltung für das schnelle Einschalten eines Highside-MOS-Leistungstransistors, wobei das Halbleiterbauelement an seinem ersten Hauptanschluß mit einem ersten Referenzpotential (z.B. positiver Batteriepol) und an seinem zweiten Hauptanschluß mit einer Last verbunden ist und wobei die Last weiterhin mit einem zweiten Referenzpotential (z.B. negativer Batteriepol) verbunden ist.

Obwohl auf beliebige steuerbare Halbleiter-Bauelemente anwendbar, werden die vorliegende Erfindung sowie die ihr zugrundeliegende Problematik in bezug auf Ansteuerschaltungen für das schnelle Einschalten eines Highside-MOS-Leistungstransistors erläutert.

Highside-MOS-Leistungstransistoren, welche in der Regel eine intelligente Zusatzbeschaltung aufweisen, sind aufgrund verschiedener Vorteile, wie z.B. Kurzschlußsicherheit für die Zuleitung und Korrosionsschutz für die Last, in vielen Anwendungsbereichen, und insbesondere in der modernen Kraftfahrzeugelektronik, weit verbreitet.

Das Einschalten eines Highside-MOS-Leistungstransistors erfordert eine Ladungspumpe, die jedoch sehr langsam ist und somit die Einschaltgeschwindigkeit begrenzt. Für Anwendungen, die eine hohe Einschaltgeschwindigkeit erfordern, z.B. im Überschallfrequenzbereich, reicht dieses Prinzip daher nicht aus.

Als Lösung bietet sich eine diskrete Bootstrap-Schaltung an, da der zugehörige Bootstrap-Kondensator aus wirtschaftlichkeitsgründen nicht auf dem Chip integriert werden kann. Eine monolithische Lösung für den Highside-MOS-Leistungstransistor und die Ansteuerschaltung (Ansteuer-IC) ist bei einem selbstisolierenden Prozeß kaum realisierbar, da die freie Verschaltbarkeit solch eines Prozesses sehr begrenzt ist.

Als Alternative bietet sich eine Zweichip-Lösung an, welche einen diskreten Bootstrap-Kondensator vorsieht. Diese Lösung kann ohne weiteres mit der Chip-on-Chip-Technologie in einem Gehäuse realisiert werden oder auch durch zwei separat montierte Chips.

Auch der separate Ansteuer-IC-Chip muß einige einschneidende Anforderungen erfüllen. Die interne IC-Schaltung, welche den Highside-MOS-Leistungstransistor ansteuert, muß die volle Batteriespannung, z. B. 12 V, aufnehmen können. Dies setzt einen Leistungs-IC-Herstellungsprozeß voraus.

Aus der DE 33 14 300 A1 ist eine Ansteuerschaltung für einen Highside-NMOS-Leistungstransistor bekannt, welcher zwischen einem ersten Referenzspannungspotential und einer Last verschaltet ist. Die Ansteuerschaltung weist ferner eine Steuersignal-Erzeugungseinrichtung auf sowie eine Serienschaltung aus einem Kondensator und einer Diode, die zwischen den Hauptanschlüssen des Leistungstransistors verschaltet ist und als Bootstrap-Einrichtung dient. Ferner ist eine steuerbare Schalteinrichtung in Form eines NPN-Bipolartransistors vorgesehen, dessen Basisanschluß über einen Fototransistor mit dem Verbindungspunkt zwischen dem Leistungstransistor und der Last verschaltet ist. Zweck der Ansteuerschaltung ist eine Schaltverzögerung in einer Leistungs-MOS FET-Gegentaktendstufe mit einem Optokoppler zu reduzieren.

In der GB 21 80 422 ist zur Ansteuerung eines Halbleiterschalters die Kombination einer Ladungspumpe mit einer Bootstrap-Schaltung vorgesehen.

Die DE 0 572 706 A1 beschreibt eine Ansteuerschaltung für einen Leistungs-FET mit sourceseitiger Last, bei der der Leistungs-FET über eine Pumpschaltung angesteuert wird. Die Pumpschaltung weist einen NPN-Bipolartransistor, einen Ladungsspeicher sowie eine Diode auf. Diese Bauelemente sind auf die Betriebsspannung $+U_{BB}$ bezogen. Die Steuerung des NPN-Bipolartransistors wird über einen MOSFET vorgenommen, der zwischen Basis und Kollektor verschaltet ist. Der Steueranschluß des MOSFETs ist mit dem Verbindungspunkt der Reihenschaltung aus einem Widerstand und einem steuerbaren Schalter verschaltet. Diese Reihenschaltung liegt zwischen einem hohen Versorgungspotential und einem Bezugspotential an. Der Steueranschluß des NPN-Bipolartransistors ist ferner über einen weiteren Widerstand mit der Last verbunden.

Dementsprechend ist es Aufgabe der vorliegenden Erfindung, eine einfache Ansteuerschaltung für ein steuerbares Halbleiterbauelement, und insbesondere eine verbesserte Ansteuerschaltung für einen Highside-MOS-Leistungstransistor zu schaffen, welche ein schnelleres Einschalten der steuerbaren Halbleiterbauelemte ermöglicht.

Erfindungsgemäß wird diese Aufgabe durch die in Anspruch 1 angegebene Ansteuerschaltung gelöst, also durch eine Ansteuerschaltung für ein Halbleiterbauelement (P1), wobei das Halbleiterbauelement (P1) mit seinem ersten Hauptanschluß (DP1) an ein erstes Referenzpotential (VBB) und mit seinem zweiten Hauptanschluß (SP1) übere eine Last (20) an ein zweites Referenzpotential (MASSE) angeschlossen ist, die folgende Merkmale aufweist:

- Eine Steuersignal-Erzeugungseinrichtung (10) zum Erzeugen eines Steuersignals (ST) für das Ein- und Ausschalten des Halbleiterbauelementes (P1) und mit einem nach den Bootstrap-Prinzip arbeitenden Schaltungsteil zum Einschalten des Halbleiterbauelementes (P1),

- eine Kondensatoreinrichtung (30), welche an ihrem ersten Anschluß über eine Diode (D1) zur Aufladung mit dem ersten Referenzpotential (VBB) und an ihrem zweiten Anschluß mit dem zweiten Hauptanschluß (SP1) des Halbleiterbauelements (P1) verbunden ist;

- Eine zwischen den ersten Anschluß der Kondensatoreinrichtung (30) und das zweite Referenzpotential (MASSE) geschaltete Reihenschaltung eines Widerstandes (R2) und eines ersten steuerbaren NMOS-Transistor (M2), welcher an seinem Steueranschluß (GM2) von dem Steuersignal (ST) beaufschlagbar ist;

- Einen ersten steuerbaren PMOS-Transistor (M1), welcher mit seinem Steueranschluß (GM1) an den Verbindungspunkt des Widerstandes (R2) und des steuerbaren Halbleiterschalters (M2) und mit seinem ersten Hauptanschluß (DM1) an den Verbindungspunkt von Diode (D1) und Kondensatoreinrichtung (30) gelegt ist;

- Einen NPN-Bipolartransistor (Q1), dessen Kollektoranschluß (C) mit dem ersten Anschluß der Kondensatoreinrichtung (30), dessen Emitteranschluß (E) mit dem Steueranschluß (GP1) des Halbleiterbauelements (P1) verbunden ist und dessen Steueranschluß (B) mit dem zweiten Hauptanschluß des ersten PMOS Transistors (M1) und über eine erste Widerstandseinrichtung (M6) an den Verbindungspunkt zwischen Last (2) und Halbleiterbauelement (P1) geschaltet ist;

- Die erste Widerstandseinrichtung (R1; M6) weist einen zweiten NMOS-Transistor (M6) auf, dessen erster Hauptanschluß (DM6) mit dem Basisanschluß (B) des NPN-Bipolartransistors (Q1), dessen zweiter Hauptanschluß (SM6) mit dem zweiten Hauptanschluß (SP1) des Halbleiterbauelements (P1) und dessen Steueranschluß (GM6) mit dem invertierten Steuersignal (ST) verbunden ist.

Die erfindungsgemäße Ansteuerschaltung weist den besonderen Vorteil auf, daß die Schalteinrichtung in Form des NPN-Bipolartransistors eine hohe Stromtragfähigkeit besitzt und durch die Schaltsteuereinrichtung schnell ein- und ausschaltbar ist.

Die der vorliegenden Erfindung zugrundeliegende Idee besteht darin, daß der Steueranschluß des Schaltelements im ausgeschalteten Zustand ein fest definiertes Potential aufweist.

In den abhängigen Ansprüchen finden sich vorteilhafte Weiterbildungen und Verbesserungen der in Anspruch 1 angegebenen Ansteuerschaltung.

Gemäß einer weiteren bevorzugten Weiterbildung ist eine Ladungspumpenschaltung zum Empfangen des Steuersignals und Ausgeben eines erhöhten Steuersignals an den Steueranschluß des Halbleiterbauelements vorgesehen. Dies bringt den Vorteil, daß die Schalteinrichtung auch permanent eingeschaltet bleiben kann (PWM(Impulsbreitenmodulations)-Tastverhältnis = 100%), sollte sich die Kondensatoreinrichtung mit der Zeit entladen.

Gemäß einer bevorzugten Weiterbildung ist das Halbleiterbauelement ein NMOS-Leistungstransistor.

Gemäß der Erfindung weist die erste Widerstandseinrichtung einen zweiten NMOS-Transistor auf, dessen erster Hauptanschluß mit dem Basisanschluß des NPN-Bipolartransistors, dessen zweiter Hauptanschluß mit dem zweiten Hauptanschluß des Halbleiterbauelements und dessen Steueranschluß mit dem invertierten Steuersignal verbunden ist. Dies hat den Vorteil, daß die erste Widerstandseinrichtung im eingeschalteten Zustand hochohmig gemacht werden kann, und daher nicht zuviel Strom ableitet, und im ausgeschalteten Zustand niederohmig gemacht werden kann, und daher die Durchbruchsspannung $V_{CE0}$ vom Schaltelement nicht zu stark reduziert wird.

Gemäß einer weiteren bevorzugten Weiterbildung ist eine zwischen den Steueranschluß und den zweiten Hauptanschluß des Halbleiterbauelements geschaltete Spannungsbegrenzungsschaltung zum Begrenzen der dazwischen liegenden Spannung vorgesehen. Damit ist es möglich, den Steueranschluß des Halbleiterbauelements vor einer Überspannung, insbesondere einer durch die Ladungspumpe verursachten Überspannung, zu schützen.

Gemäß einer weiteren bevorzugten Weiterbildung weist die Spannungsbegrenzungsschaltung eine Zenerdiode, deren Kathodenanschluß mit dem Steueranschluß des Halbleiterbauelements verbunden ist; und einen dritten NMOS-Transistor, dessen erster Hauptanschluß mit dem Anodenanschluß der Zenerdiode verbunden ist, dessen zweiter Hauptanschluß mit dem zweiten Hauptanschluß des Halbleiterbauelements und dessen Steueranschluß mit dessen ersten Hauptanschluß verbunden ist, auf.

Gemäß einer weiteren bevorzugten Weiterbildung ist eine Ladungspumpen-Aktivierungsschaltung zum Aktivieren der Ladungspumpenschaltung in Abhängigkeit von der Spannung vorgesehen. So ist es möglich, die Ladungspumpe nur bei Bedarf, also z.B. nicht bei einem reinen PWM(Impulsbreiten-modulations)-Betrieb im hohen Frequenzbereich, mitlaufen zu lassen und keine unnötige EMV-Störung zu erzeugen.

Gemäß einer weiteren bevorzugten Weiterbildung weist die Ladungspumpen-Aktivierungsschaltung eine Verzögerungseinrichtung zum Empfangen und Verzögern des Steuersignals; eine eine Hysterese aufweisende Invertereinrichtung zum Empfangen und Invertieren des am ersten Steueranschluß des dritten NMOS-Transistors anliegenden Potentials; und eine UND-Gattereinrichtung zum Empfangen der Ausgangssignale der Verzögerungseinrichtung und der die Hysterese aufweisenden Invertereinrichtung und Ausgeben eines entsprechend verknüpften Ausgangssignals zum Aktivieren der Ladungspumpenschaltung auf.

Gemäß einer weiteren bevorzugten Weiterbildung ist eine Spannungsregelungsschaltung zum Erfassen der zwischen dem Steueranschluß und dem zweiten Hauptanschluß des Halbleiterbauelements liegenden Spannung und Regeln der Ansteuerung des Schaltelements in Abhängigkeit davon auf. Damit ist es möglich, den Steueranschluß des Halbleiterbauelements weitergehender vor einer Überspannung, insbesondere einer durch die Kondensatoreinrichtung oder Batterie verursachten Überspannung, zu schützen.

Gemäß einer weiteren bevorzugten Weiterbildung weist die Spannungsregelungsschaltung eine zweite Widerstandseinrichtung, deren erster Anschluß mit dem ersten Anschluß der Kondensatoreinrichtung verbunden ist; einen vierten NMOS-Transistor, dessen erster Hauptanschluß mit dem zweiten Anschluß der dritten Widerstandseinrichtung, dessen zweiter Hauptanschluß mit dem zweiten Hauptanschluß des Halbleiterbauelements und dessen Steueranschluß mit dem Steueranschluß des dritten NMOS-Transistors verbunden ist; und einen zweiten PMOS-Transistor, dessen erster Hauptanschluß mit dem ersten Anschluß der Kondensatoreinrichtung, dessen zweiter Hauptanschluß mit dem Steueranschluß des ersten PMOS-Transistors und dessen Steueranschluß mit dem zweiten Anschluß der zweiten Widerstandseinrichtung verbunden ist.

Gemäß einer weiteren bevorzugten Weiterbildung ist zwischen dem zweiten Hauptanschluß des zweiten PMOS-Transistors und dem ersten Hauptanschluß des vierten NMOS-Transistors eine Reihenschaltung aus einer dritten Widerstandseinrichtung und einer zweiten Kondensatoreinrichtung zur Stabilisierung der Regelung vorgesehen.

Ausführungsbeispiele der Erfindung sind in den Zeichnungen dargestellt und in der nachfolgenden Beschreibung näher erläutert. Es zeigen:

Fig. 1    eine Ausführungsform einer Ansteuerschaltung;

Fig. 2    eine erste bevorzugte Ausführungsform der erfindungsgemäßen Ansteuerschaltung; und

Fig. 3    eine Darstellung der Realisierung von D1, Q1 und M1 in einem selbstisolierenden Herstellungsprozeß.

In den Figuren bezeichnen gleiche Bezugszeichen gleiche oder funktionsgleiche Bestandteile.

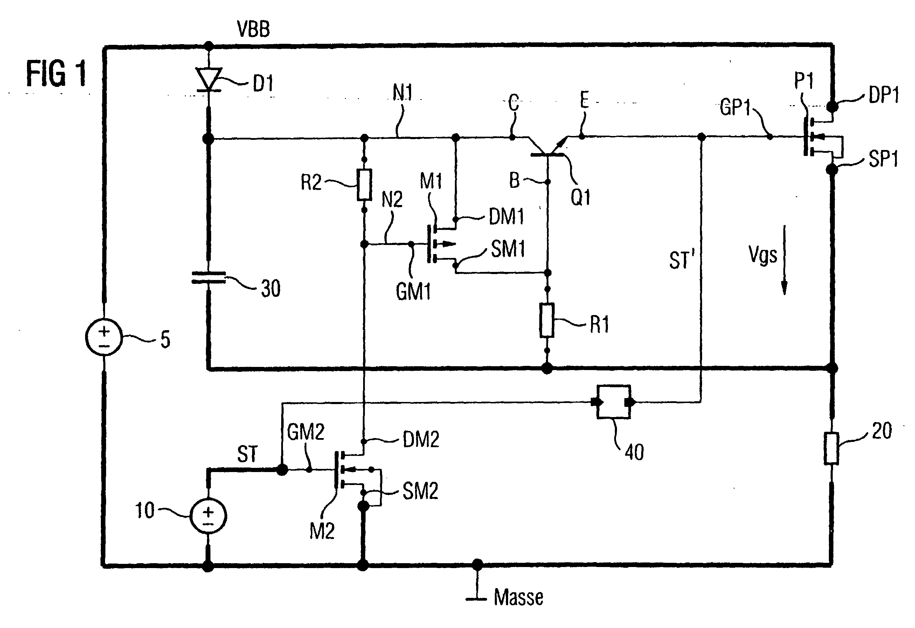

Fig. 1 zeigt eine Ausführungsform einer Ansteuerschaltung.

In Fig. 1 bezeichnet Bezugszeichen P1 einen Highside-NMOS-Leistungstransistor, der an seinem ersten Hauptanschluß DP1 mit einem ersten Referenzpotential VBB (positiver Pol einer Batterie 5) und an seinem zweiten Hauptanschluß SP1 mit einer Last 20 verbunden ist, wobei die Last 20 weiterhin mit einem zweiten Referenzpotential MASSE (negativer Pol der Batterie 5) verbunden ist.

Bezugszeichen 30 bezeichnet einen Kondensator, welcher an seinem ersten Anschluß über eine Diode D1 zur Aufladung mit dem ersten Referenzpotential VBB und an seinem zweiten Anschluß mit dem zweiten Hauptanschluß SP1 des Highside-NMOS-Leistungstransistor P1 verbunden ist.

Bezugszeichen Q1 bezeichnet eine Schalteinrichtung in Form eines NPN-Bipolartransistors, dessen Kollektoranschluß C mit dem ersten Anschluß des Kondensators 30 (Knoten N1), dessen Emitteranschluß E mit dem Steueranschluß GP1 des Highside-NMOS-Leistungstransistor P1 und dessen Basisanschluß B über einen ersten Widerstand R1 mit dem zweiten Hauptanschluß SP1 des Highside-NMOS-Leistungstransistor P1 verbunden ist.

Die Schalteinrichtung, also der NPN-Bipolartransistor Q1, ist derart steuerbar, daß sie die in dem Kondensator 30 gespeicherte Ladung im Einschaltzustand an den Steueranschluß GP1 des Highside-NMOS-Leistungstransistor P1 zuführt und im Ausschaltzustand nicht.

Dazu ist eine Schaltsteuereinrichtung zum Steuern des NPN-Bipolartransistors Q1 ansprechend auf das Steuersignal ST einer Steuersignal-Erzeugungseinrichtung 10 vorgesehen.

Die Schaltsteuereinrichtung weist einen ersten PMOS-Transistor M1 auf, dessen erster Hauptanschluß DM1 mit dem Kollektoranschluß C des NPN-Bipolartransistors Q1 und dessen zweiter Hauptanschluß SM1 mit dem Basisanschluß B des NPN-Bipolartransistors Q1 verbunden ist. Weiterhin weist die Schaltsteuereinrichtung einen zweiten Widerstand R2 auf, dessen erster Anschluß mit dem ersten Anschluß der Kondensatoreinrichtung 30 (Knoten N1) verbunden ist, sowie einen ersten NMOS-Transistor M2, dessen erster Hauptanschluß DM2 mit dem zweiten Anschluß des zweiten Widerstands R2 (Knoten N2) und mit dem Steueranschluß GM1 des ersten PMOS-Transistors M1, dessen zweiter Hauptanschluß SM2 mit dem zweiten Referenzpotential MASSE und dessen Steueranschluß mit dem Steuersignal ST verbunden ist.

Schließlich enthält die erste Ausführungsform eine Ladungspumpenschaltung 40 zum Empfangen des Steuersignals ST und Ausgeben eines potentialmäßig erhöhten Steuersignals ST' an den Steueranschluß GP1 des Highside-NMOS-Leistungstransi-stors P1.

Im folgenden wird die Betriebsweise des Ansteuerkonzeptes gemäß der ersten Ausführungsform der Erfindung näher erläutert.

Der diskrete Kondensator 30 wird im Ausschaltzustand des Highside-NMOS-Leistungstransistors P1, d.h. Steuersignal ST ist auf L, über die Diode D1 aufgeladen. Dabei ist der erste PMOS-Transistor M1, der dem NPN-Bipolartransistor Q1 den Basisstrom zur Verfügung stellt, ausgeschaltet und der erste NMOS-Transistor M2 ausgeschaltet.

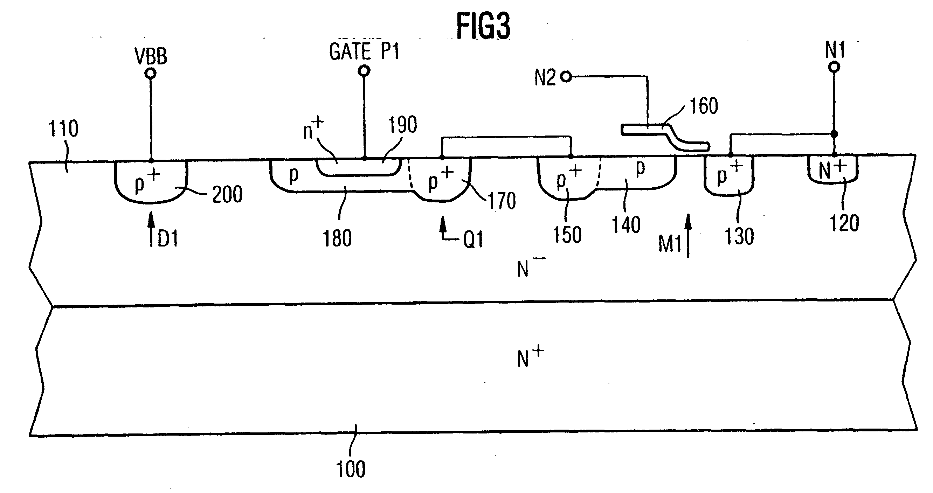

Der NPN-Bipolartransistor Q1 sperrt durch geeignete Ansteuerung in beiden Richtungen, insbesondere in Vorwärtsrichtung die gesamte positive Spannung VBB der Batterie 5. Es ist daher zweckmäßig, wenn der Kollektoranschluß C des NPN-Bipolartransistors Q1 und damit auch die Kathode der Diode D1 (Knoten N1) vom Substrat gebildet sind (vgl. Fig. 3 und entsprechende Beschreibung weiter unten). Dies ist bei einem selbstisolierenden Prozeß notwendig.

Der Widerstand R1 verbindet den Basisanschluß B des NPN-Bipolartransistors Q1 mit dem zweiten Hauptanschluß SP1 des Highside-NMOS-Leistungstransistors P1 und sorgt so im Ausschaltzustand für ein fest definiertes Basispotential.

Der diskrete Kondensator 30 wird im Einschaltzustand des Highside-NMOS-Leistungstransistors P1, d.h. Steuersignal ST ist auf H, über den NPN-Bipolartransistor zum Steueranschluß GP1 des Highside-NMOS-Leistungstransistors P1 entladen und sorgt so für ein schnelles Einschalten.

Dabei ist der erste PMOS-Transistor M1, der dem NPN-Bipolartransistor Q1 den Basisstrom zur Verfügung stellt, eingeschaltet und der erste MMOS-Transistor M2 eingeschaltet.

Da der Kondensator 30 und der Steueranschluß GP1 des Highside-NMOS-Leistungstransistors P1 im Einschaltzustand mit der Zeit entladen werden können, ist die Zuschaltung der Ladungspumpe 40 vorgesehen. Damit kann der Highside-NMOS-Leistungstränsistors P1 längere Zeit permanent eingeschaltet bleiben.

Aus folgenden Überlegungen heraus ist es zweckmäßig, die in Fig. 1 gezeigte erste Ausführungsform der erfindungsgemäßen Ansteuerschaltung weiter zu verbessern.

Wenn die Spannung der Batterie 5 groß ist und Q1 durchgeschaltet ist, bildet beinahe die volle Batteriespannung VBB die Spannung Vgs zwischen Gateanschluß GP1 und Sourceanschluß SP1 des Highside-NMOS-Leistungstransistors P1.

Wenn der Kondensator 30 entladen ist, ist die Basis-Emitter-Diode des NPN-Bipolartransistors Q1 durch die Spannung Vgs in Sperrichtung gepolt. Das Gateoxid verträgt aber nur eine begrenzte Spannung. Ebenso ist die Durchbruchsspannung der Emitter-Diode des NPN-Bipolartransistors Q1 begrenzt. Eine Begrenzung von Vgs ist daher zweckmäßig.

Weiterhin sollte der Widerstand R1 im Ausschaltzustand niederohmig sein, damit die Durchbruchsspannung $V_{CE0}$ des NPN-Transistors Q1 nicht zu stark reduziert wird. Im Einschaltzustand hingegen sollte der Widerstand R1 hochohmig sein, damit der Kondensator 30 nicht unnötig entladen wird. Daher bietet sich ein zustandsabhängig steuerbarer Widerstand an, beispielsweise ein Transistor.

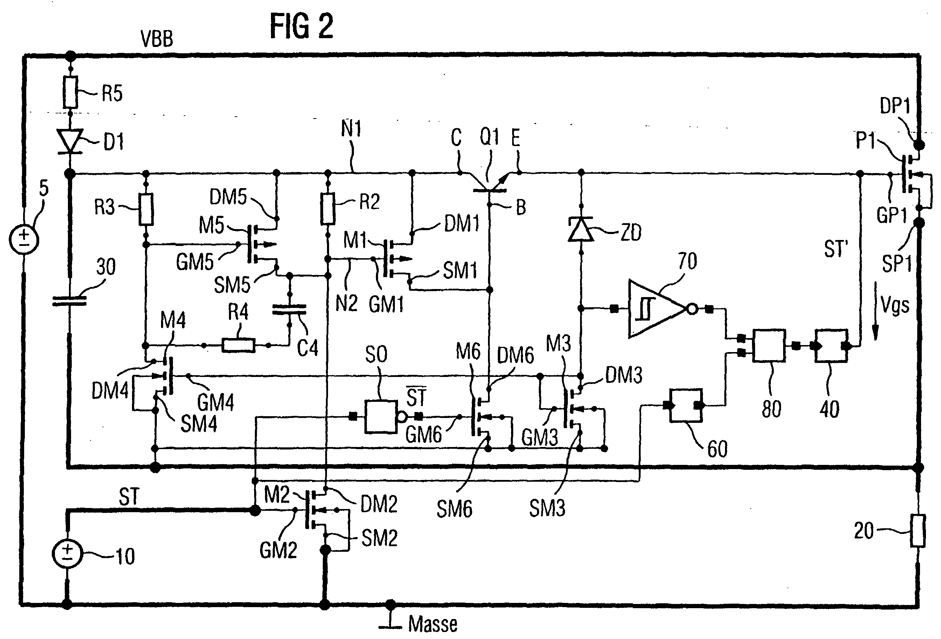

Fig. 2 zeigt eine zweite bevorzugte Ausführungsform der erfindungsgemäßen Ansteuerschaltung.

In der in Fig. 2 gezeigten Ansteuerschaltung ist der erste Widerstand R1 von Fig. 1 durch einen zweiten NMOS-Transistor M6 ersetzt, dessen erster Hauptanschluß DM6 mit dem Basisanschluß B des NPN-Bipolartransistors Q1, dessen zweiter Hauptanschluß SM6 mit dem zweiten Hauptanschluß SP1 des Highside-NMOS-Leistungstransistors P1 und dessen Steueranschluß GM6 mit dem durch den Inverter 50 invertierten Steuersignal ST verbunden ist.

Dadurch sind der Basisanschluß B des NPN-Transistors Q1 und der zweite Hauptabschluß SP1 des Highside-NMOS-Leistungstransistors P1 im Ausschaltzustand kurzgeschlossen.

Im übrigen werden auch der Steueranschluß GP1 und der zweite Hauptabschluß SP1 des Highside-NMOS-Leistungstransi-stors P1 im Ausschaltzustand durch eine (nicht gezeigte) Pulldown-Schaltung kurzgeschlossen, damit volle Sperrfähigkeit des NPN-Transistors Q1 so schnell wie möglich erhalten wird.

Weiterhin ist bei der zweiten Ausführungsform zusätzlich eine zwischen den Steueranschluß GP1 und den zweiten Hauptanschluß SP1 Highside-NMOS-Leistungstransistors P1 geschaltete Spannungsbegrenzungsschaltung zum Begrenzen der dazwischen liegenden Spannung Vgs vorgesehen.

Die Spannungsbegrenzungsschaltung weist eine Zenerdiode ZD, deren Kathodenanschluß mit dem Steueranschluß GP1 Highside-NMOS-Leistungstransistors P1 verbunden ist, und einen dritten NMOS-Transistor M3, dessen erster Hauptanschluß DM3 mit dem Anodenanschluß der Zenerdiode ZD verbunden ist, dessen zweiter Hauptanschluß SM3 mit dem zweiten Hauptanschluß SP1 Highside-NMOS-Leistungstransistors P1 und dessen Steueranschluß GM3 mit dessen ersten Hauptanschluß DM3 verbunden ist, auf.

Diese Spannungsbegrenzungsschaltung begrenzt insbesondere die durch die Ladungspumpe 40 erzeugte Überspannung, da die Ladungspumpe 40 nur einen kleinen Strom liefert.

Das Potential am Steueranschluß GM3 des dritten NMOS-Transistors M3 wird bei der zweiten Ausführungsform ferner dazu verwendet, durch eine Ladungspumpen-Aktivierungsschaltung die Ladungspumpe 40 in Abhängigkeit von der Spannung Vgs zu aktivieren bzw. zu deaktivieren.

Insbesondere weist die Ladungspumpen-Aktivierungsschaltung eine Verzögerungseinrichtung 60 zum Empfangen und Verzögern des Steuersignals ST, eine eine Hysterese aufweisende Invertereinrichtung 70 zum Empfangen und Invertieren des am ersten Steueranschluß GM3 des dritten NMOS-Transistors M3 anliegenden Potentials und ein UND-Gatter 80 zum Empfangen der Ausgangssignale der Verzögerungseinrichtung 60 und der die Hysterese aufweisenden Invertereinrichtung 70 und zum Ausgeben eines entsprechend verknüpften Ausgangssignals zum Aktivieren der Ladungspumpe 40 auf. Die Zeitkonstante der Verzögerung der Verzögerungseinrichtung 60 ist in der Größenordnung der Einschaltzeit mit dem Bootstrapkondensator 30.

Solange Vgs begrenzt wird, bedeutet dies, daß Vgs groß genug ist, also die Ladungpumpe 40 nicht benötigt ist. Beim oder kurz nach dem Einschalten kann die Spannung Vgs noch nicht groß sein, die Ladungspumpe 40 schafft aber keine Abhilfe, da sie langsam bzw. schwach ist. Die Verzögerung durch das mittels der Verzögerungseinrichtung 60 verzögerte Einschalten der Ladungspumpe 40 ist also vernachlässigbar. So läuft die Ladungspumpe 40 bei einem reinen PWM(Impulsbreitenmodulations)-Betrieb im hohen Frequenzbereich überhaupt nicht und erzeugt daher auch keine EMV-Störung (elektro-magnetische Verträglichkeit). Erst nach Ablauf der Verzögerungszeit der Verzögerungseinrichtung 60 und unter der Bedingung, daß Vgs nicht begrenzt wird, d.h. nicht groß genug ist, z.B. weil der Kondensator 30 nicht angeschlossen ist oder die Gatekapazität des Highside-NMOS-Leistungstransistors P1 entladen ist, läuft die Ladungspumpe 40. Diese Ausführungsform garantiert also auch das Einschalten ohne den Kondensator 30 und einen statischen Einschaltbetrieb.

Wie oben erwähnt, dient die Spannungsbegrenzungsschaltung, welche die Zenerdiode ZD und die "MOS-Diode" M3 aufweist, in erster Linie zur Begrenzung der durch die Ladungspumpe 40 verursachten Überspannung von Vgs. Die Überspannung kann aber auch durch den Kondensator 30 verursacht werden. Solch eine Überspannung kann die Diodenkette ZD, M3 aber in der Regel nicht begrenzen, da der Kondensator 30 eine große Kapazität aufweist und die Batteriespannung VBB groß ist und große Schwankungen aufweisen kann. Außerdem würde durch solch eine Entladung die Wiederaufladung des Kondensators 30 eine hohen Ladestrom und längere Zeit beanspruchen.

Daher ist bei der zweiten Ausführungsform zusätzlich eine Spannungsregelungsschaltung zum Erfassen der zwischen dem Steueranschluß GP1 und dem zweiten Hauptanschluß SP1 des Halbleiterbauelements P1 liegenden Spannung Vgs und Regeln der Ansteuerung des NPN-Bipolartransistors Q1 in Abhängigkeit davon vorgesehen.

Die Spannungsregelungsschaltung weist einen dritten Widerstand R3, dessen erster Anschluß mit dem ersten Anschluß des Kondensators 30 verbunden ist, einen vierten NMOS-Transistor M4, dessen erster Hauptanschluß DM4 mit dem zweiten Anschluß des dritten Widerstands R3, dessen zweiter Hauptanschluß SM4 mit dem zweiten Hauptanschluß SP1 des Highside-NMOS-Leistungstransistors P1 und dessen Steueranschluß GM4 mit dem Steueranschluß GM3 des dritten NMOS-Transistors M3 verbunden ist, sowie einen zweiten PMOS-Transistor M5, dessen erster Hauptanschluß DM5 mit dem ersten Anschluß des Kondensators 30, dessen zweiter Hauptanschluß SM5 mit dem Steueranschluß GM1 des ersten PMOS-Transistors M1 und dessen Steueranschluß GM5 mit dem zweiten Anschluß des dritten Widerstands R3 verbunden ist, auf.

Zwischen dem zweiten Hauptanschluß SM5 des zweiten PMOS-Transistors M5 und dem ersten Hauptanschluß DM4 des vierten NMOS-Transistors M4 ist eine Reihenschaltung aus einem vierten Widerstand R4 und einem zweiten Kondensator C4 zur Stabilisierung der Regelung vorgesehen.

Der Widerstand R5 dient der Begrenzung der Ladestroms des Kondensators 30.

Das Potential am Steueranschluß des dritten NMOS-Transistors M3, welches ja auch die Spannungsbegrenzung durch die Diodenkette ZD, M3 anzeigt, liefert auch das Signal für die Regelung von dem ersten PMOS-Transistor M1 und damit auch vom NPN-Bipolartransistor Q1. Der Pegel dieses Signals wird mit dem vierten NMOS-Transistor M4 und dem Widerstand R3 nach oben zum Knoten N1 hin umgesetzt und mit dem zweiten PMOS-Transistor M5 der Steueranschluß SM1 von dem ersten PMOS-Transistor M1 geregelt.

Fig. 3 zeigt eine Darstellung der Realisierung von D1, Q1 und M1 in einem selbstisolierenden Herstellungsprozeß.

In Fig. 3 bezeichnet Bezugszeichen 100 ein $N^+$-Substrat, 110 eine $N^-$-Epischicht, 120 ein erstes $N^+$-Gebiet, 130 ein erstes $P^+$-Gebiet, 140 ein erstes P-Gebiet, 150 ein zweites $P^+$-Gebiet, 160 eine Gate-Elektrode, 170 ein drittes $P^+$-Gebiet, 180 ein zweites P-Gebiet, 190 ein zweites $N^+$-Gebiet und 200 ein viertes $P^+$-Gebiet.

Das erste $N^+$-Gebiet 120 bildet den Knoten N1 in Fig. 1 und 2. Es ist mit dem Drain-Anschluß des PMOS-Transistors M1 verbunden, welcher das erste $P^*$-Gebiet 130 als Drain und das erste P-Gebiet 140 sowie das zweite $P^*$-Gebiet 150 als Source mit einem dazwischenliegenden $N^-$-Kanal, über dem sich die Gate-Elektrode 160 befindet, aufweist. Die Gate-Elektrode 160 ist mit dem Knoten N2 in Fig. 1 und 2 verbunden.

Der Source-Anschluß des Transistors M1 ist mit dem dritten $P^+$-Gebiet 170 verbunden, welches zusammen mit dem zweiten P-Gebiet 180 die Basis des NPN-Transistors Q1 bildet, dessen Kollektor das $N^-$-Gebiet 110 und dessen Emitter das $N^+$-Gebiet 190 bildet. Der Kollektor ist mit dem Gate-Anschluß des NMOS-Leistungstransistors P1 verbunden.

Schließlich bildet das vierte P+-Gebiet 200 zusammen mit dem $N^-$-Gebiet 110 die Diode D1, welche anodenseitig mit dem ersten Referenzpotential VBB und kathodenseitig mit dem Knoten N1 verbunden ist.

Anforderungsgemäß hat die Diode D1 eine hohe Sperrfähigkeit und der NPN-Transistor Q1 eine hohe Sperrfähigkeit und eine hohe Verstärkung. Auch der PMOS-Transistor M1 hat eine hohe Sperrfähigkeit. Die gezeigte Realisierung ist flächensparend und äußerst robust.

Obwohl die vorliegende Erfindung anhand zweier bevorzugter Ausführungsbeispiel vorstehend beschrieben wurde, ist sie darauf nicht beschränkt, sondern auf vielfältige Weise modifizierbar.

Als steuerbares Halbleiterbauelement kann nicht nur der gezeigte NMOS-Leistungstransistor, sondern können auch ein PMOS-Leistungstransistor oder beliebige andere steuerbare Halbleiterbauelemente, wie z.B. IGBTs oder Thyristoren, verwendet werden.

Die Spannungsbegrenzungsschaltung kann durch eine beliebige Kombination von Zenerdioden und MOS-Dioden auf eine gewünschte Spannungsbegrenzung eingestellt werden.

Die Ansteuerschaltung kann nicht nur mit dem gezeigten selbstisolierenden Prozeß, sondern auch mit einem besser isolierenden Prozeß wie Junction-Isolation (JI) oder Doppel-Isolation (DI) hergestellt werden.

**Patentansprüche**

1. Ansteuerschaltung für ein Halbleiterbauelement (P1), wobei das Halbleiterbauelement (P1) mit seinem ersten Hauptanschluß (DP1) an ein erstes Referenzpotential (VBB) und mit seinem zweiten Hauptanschluß (SP1) über eine Last (20) an ein zweites Referenzpotential (MASSE) angeschlossen ist, die folgende Merkmale aufweist:

   - Eine Steuersignal-Erzeugungseinrichtung (10) zum Erzeugen eines Steuersignals (ST) für das Ein- und Ausschalten des Halbleiterbauelementes (P1) und mit einem nach den Bootstrap-Prinzip arbeitenden Schaltungsteil zum Einschalten des Halbleiterbauelementes (P1),

   - eine Kondensatoreinrichtung (30), welche an ihrem ersten Anschluß über eine Diode (D1) zur Aufladung mit dem ersten Referenzpotential (VBB) und an ihrem zweiten Anschluß mit dem zweiten Hauptanschluß (SP1) des Halbleiterbauelements (P1) verbunden ist;

   - Eine zwischen den ersten Anschluß der Kondensatoreinrichtung (30) und das zweite Referenzpotential (MASSE) geschaltete Reihenschaltung eines Widerstandes (R2) und eines ersten steuerbaren NMOS-Transistor (M2), welcher an seinem Steueranschluß (GM2) von dem Steuersignal (ST) beaufschlagbar ist;

   - Einen ersten steuerbaren PMOS-Transistor (M1), welcher mit seinem Steueranschluß (GM1) an den Verbindungspunkt des Widerstandes (R2) und des steuerbaren Halbleiterschalters (M2) und mit seinem ersten Hauptanschluß (DM1) an den Verbindungspunkt von Diode (D1) und Kondensatoreinrichtung (30) gelegt ist;

   - Einen NPN-Bipolartransistor (Q1), dessen Kollektoranschluß (C) mit dem ersten Anschluß der Kondensatoreinrichtung (30), dessen Emitteranschluß (E) mit dem Steueranschluß (GP1) des Halbleiterbauelements (P1) verbunden ist und dessen Steueranschluß (B) mit dem zweiten Hauptanschluß des ersten PMOS Transistors (M1) und über eine erste Widerstandseinrichtung (M6) an den Verbindungspunkt zwischen Last (2) und Halbleiterbauelement (P1) geschaltet ist.

   - Die erste Widerstandseinrichtung (M6) weist einen zweiten NMOS-Transistor (M6) auf, dessen erster Hauptanschluß (DM6) mit dem Basisanschluß (B) des NPN-Bipolartransistors (Q1), dessen zweiter Hauptanschluß (SM6) mit dem zweiten Hauptanschluß (SP1) des Halbleiterbauelements (P1) und dessen Steueranschluß (GM6) mit dem invertierten Steuersignal (ST) verbunden ist.

2. Ansteuerschaltung nach Anspruch 1, **gekennzeichnet durch** eine Ladungspumpenschaltung (40) zum Empfangen des Steuersignals (ST) und Ausgeben eines erhöhten Steuersignals (ST') an den Steueranschluß (GP1) des Halbleiterbauelements (P1).

3. Ansteuerschaltung nach Anspruch 1 oder 2, **dadurch gekennzeichnet, daß** das Halbleiterbauelement (P1) ein NMOS-Leistungstransistor ist.

4. Ansteuerschaltung nach einem der vorhergehenden Ansprüche, **gekennzeichnet durch** eine zwischen den Steueranschluß (GP1) und den zweiten Hauptanschluß (SP1) des Halbleiterbauelements (P1) geschaltete Spannungsbegrenzungsschaltung (ZD, M3) zum Begrenzen der dazwischen liegenden Spannung (Vgs).

5. Ansteuerschaltung nach Anspruch 4, **dadurch gekennzeichnet, daß** die Spannungsbegrenzungsschaltung (ZD, M3) aufweist:

   eine Zenerdiode (ZD), deren Kathodenanschluß mit dem Steueranschluß (GP1) des Halbleiterbauelements (P1) verbunden ist; und

   einen dritten NMOS-Transistor (M3), dessen erster Hauptanschluß (DM3) mit dem Anodenanschluß der Zenerdiode (ZD) verbunden ist, dessen zweiter Hauptanschluß (SM3) mit dem zweiten Hauptanschluß (SP1) des Halbleiterbauelements (P1) und dessen Steueranschluß (GM3) mit dessen ersten Hauptanschluß (DM3) verbunden ist.

6. Ansteuerschaltung nach Anspruch 5, **gekennzeichnet durch** eine Ladungspumpen-Aktivierungsschaltung (60, 70, 80) zum Aktivieren der Ladungspumpenschaltung (40) in Abhängigkeit von der Spannung (Vgs).

7. Ansteuerschaltung nach Anspruch 6, **dadurch gekennzeichnet, daß** die Ladungspumpen-Aktivierungsschaltung (60, 70, 80) aufweist:

eine Verzögerungseinrichtung (60) zum Empfangen und Verzögern des Steuersignals (ST);

eine eine Hysterese aufweisende Invertereinrichtung (70) zum Empfangen und Invertieren des am ersten Steueranschluß (GM3) des dritten NMOS-Transistors (M3) anliegenden Potentials; und

eine UND-Gattereinrichtung (80) zum Empfangen der Ausgangssignale der Verzögerungseinrichtung (60) und der die Hysterese aufweisenden Invertereinrichtung (70) und Ausgeben eines entsprechend verknüpften Ausgangssignals zum Aktivieren der Ladungspumpenschaltung (40).

8. Ansteuerschaltung nach einem der vorhergehenden Ansprüche, **gekennzeichnet durch** eine Spannungsregelungsschaltung (R3, M4, R4, C4, M5; ZD, M3) zum Erfassen der zwischen dem Steueranschluß (GP1) und dem zweiten Hauptanschluß (SP1) des Halbleiterbauelements (P1) liegenden Spannung (Vgs) und Regeln der Ansteuerung des Schaltelements (Q1) in Abhängigkeit davon.

9. Ansteuerschaltung nach Anspruch 8, **dadurch gekennzeichnet, daß** die Spannungsregelungsschaltung (R3, M4, R4, C4, M5; ZD, M3) aufweist:

eine zweite Widerstandseinrichtung (R3), deren erster Anschluß mit dem ersten Anschluß der Kondensatoreinrichtung (30) verbunden ist;

einen vierten NMOS-Transistor (M4), dessen erster Hauptanschluß (DM4) mit dem zweiten Anschluß der zweite Widerstandseinrichtung (R3), dessen zweiter Hauptanschluß (SM4) mit dem zweiten Hauptanschluß (SP1) des Halbleiterbauelements (P1) und dessen Steueranschluß (GM4) mit dem Steueranschluß (GM3) des dritten NMOS-Transistors (M3) verbunden ist; und

einen zweiten PMOS-Transistor (M5), dessen erster Hauptanschluß (DM5) mit dem ersten Anschluß der Kondensatoreinrichtung (30), dessen zweiter Hauptanschluß (SM5) mit dem Steueranschluß (GM1) des ersten PMOS-Transistors (M1) und dessen Steueranschluß (GM5) mit dem zweiten Anschluß der zweite Widerstandseinrichtung (R3) verbunden ist.

10. Ansteuerschaltung nach Anspruch 9, **dadurch gekennzeichnet, daß** zwischen dem zweiten Hauptanschluß (SM5) des zweiten PMOS-Transistors (M5) und dem ersten Hauptanschluß (DM4) des vierten NMOS-Transistors (M4) eine Reihenschaltung aus einer dritten Widerstandseinrichtung (R4) und einer zweiten Kondensatoreinrichtung (C4) zur Stabilisierung der Regelung vorgesehen ist.

## Claims

1. A control circuit for a semiconductor component (P1), wherein the semiconductor component (P1) is connected by its first main terminal (DPI) to a first reference potential (VBB) and by its second main terminal (SP1) via a load (20) to a second reference potential (EARTH), which circuit comprises the following features:

   - a control signal generating device (10) for generating a control signal (ST) for turning on and off the semiconductor component (P1) and with a circuit part working in accordance with the bootstrap principle for turning on the semiconductor component (P1),

   - a capacitor device (30), which is connected at its first terminal via a diode (D1) for charging to the first reference potential (VBB) and at its second terminal to the second main terminal (SP1) of the semiconductor component (P1);

   - a series circuit, connected between the first terminal of the capacitor device (30) and the second reference potential (EARTH), consisting of a resistor (R2) and a first controllable NMOS transistor (M2), which can be supplied at its gate terminal (GM2) with the control signal (ST);

   - a first controllable PMOS transistor (M1), which is laid with its gate terminal (GM1) at the connection point of the resistor (R2) and the controllable semiconductor switch (M2) and with its first main terminal (DM1) at the connection point of diode (D1) and capacitor device (3);

   - an NPN bipolar transistor (Q1), the collector terminal (C) of which is connected to the first terminal of the capacitor device (30), the emitter terminal (E) of which is connected to the gate terminal (GP1) of the semiconductor component (P1) and the gate terminal (B) of which is connected to the second main terminal of the first PMOS transistor (M1) and via a first resistor device (M6) is connected to the connection point between load (2) and semiconductor component (P1).

   - The first resistor device (M6) comprises a second NMOS transistor (M6), the first main terminal (DM6) of which is connected to the base terminal (B) of the NPN bipolar transistor (Q1), the second main terminal (SM6) of which is connected to the second main terminal (SP1) of the semiconductor component (P1) and the gate terminal (GM6) of which is connected to the inverted control signal (ST).

2. A control circuit according to Claim 1, **characterised by** a charge pump circuit (40) for receiving the control signal (ST) and outputting an incremented control signal (ST') to the gate terminal (GP1) of the semiconductor component (P1).

3. A control circuit according to Claim 1 or 2, **characterised in that** the semiconductor component (P1) is an NMOS power transistor.

4. A control circuit according to one of the preceding Claims, **characterised by** a voltage limitation circuit (ZD, M3) connected between the gate terminal (GP1) and the second main terminal (SP1) of the semiconductor component (P1) to limit the voltage (Vgs) lying between them.

5. A control circuit according to Claim 4, **characterised in that** the voltage limitation circuit (ZD, M3) comprises:

a Zener diode (ZDF), the cathode terminal of which is connected to the gate terminal (GP1) of the semiconductor component (P1); and

a third NMOS transistor (M3), the first main terminal (DM3) of which is connected to the anode terminal of the Zener diode (ZD), the second main terminal (SM3) of which is connected to the second main terminal (SP1) of the semiconductor component (P1) and the gate terminal (GM3) of which is connected to its first main terminal (DM3).

6. A control circuit according to Claim 5, **characterised by** a charge pump activation circuit (60, 70, 80) for activating the charge pump circuit (40) in dependence on the voltage (Vgs).

7. A control circuit according to Claim 6, **characterised in that** the charge pump activation circuit (60, 70, 80) comprises:

a delay device (60) for receiving and delaying the control signal (ST);

an inverter device (70), comprising a hysteresis, for receiving and inverting the potential lying at the first gate terminal (GM3) of the third NMOS transistor (M3); and

an AND gate device (80) for receiving the output signals of the delay device (60) and of the inverter device (70) comprising the hysteresis and for outputting a correspondingly linked output signal for activating the charge pump circuit (40).

8. A control circuit according to one of the preceding Claims, **characterised by** a voltage regulation circuit (R3, M4, R4, C4, M5; ZD, M3) for recording the voltage (Vgs) lying between the gate terminal (GP1) and the second main terminal (SP1) of the semiconductor component (P1) and for regulating the triggering of the switching element (Q1) in dependence thereon.

9. A control circuit according to Claim 8, **characterised in that** the voltage regulation circuit (R3, M4, R4, C4, M5; ZD, M3) comprises:

a second resistor device (R3), the first terminal of which is connected to the first terminal of the capacitor device (30);

a fourth NMOS transistor (M4), the first main terminal (DM4) of which is connected to the second terminal of the second resistor device (R3), the second main terminal (SM4) of which is connected to the second main terminal (SP1) of the semiconductor component (P1) and the gate terminal (GM4) of which is connected to the gate terminal (GM3) of the third NMOS transistor (M3); and

a second PMOS transistor (M5), the first main terminal (DM5) of which is connected to the first terminal of the capacitor device (30), the second main terminal (SM5) of which is connected to the gate terminal (GM1) of the first PMOS transistor (M1) and the gate terminal (GM5) of which is connected to the second terminal of the second resistor device (R3).

10. A control circuit according to Claim 9, **characterised in that** a series circuit consisting of a third resistor device (R4) and a second capacitor device (C4) is provided between the second main terminal (SM5) of the second PMOS transistor (M5) and the first main terminal (DM4) of the fourth NMOS transistor (M4) to stabilise the closed-loop control.

**Revendications**

1. Circuit de commande d'un composant semi-conducteur (P1), ce composant (P1) ayant une première borne principale (DP1) reliée à un premier potentiel de référence (VBB) et une seconde borne principale (SP1) reliée par une charge (20) à un second potentiel de référence (MASSE), **caractérisé en ce qu'**il comprend :

- un générateur de signal de commande (10) qui génère un signal de commande (ST) pour brancher et couper le composant semi-conducteur (P1) et une partie de circuit fonctionnant selon le principe de démarrage pour brancher le composant semi-conducteur (P1),
- un condensateur (30) dont la première borne est reliée par une diode (D1) de charge au premier potentiel de référence (VBB) et dont la seconde borne est reliée à la seconde borne principale (SP1) du composant semi-conducteur (P1),
- un montage en série d'une résistance (R2) et d'un premier transistor commandé NMOS, (M2), branché entre la première borne du condensateur (30) et le second potentiel de référence (MASSE) ce transistor (M2) recevant le signal de commande (ST) sur sa borne de commande (GM2),
- un premier transistor PMOS, commandé (M1) dont la borne de commande (GM1) est reliée au point de combinaison de la résistance (R2) et du commutateur semi-conducteur commandé (M2) et dont la première borne principale (DM1) est reliée au point de liaison entre la diode (D1) et le condensateur (30),
- un transistor bipolaire NPN (Q1) dont le collecteur (C) est relié à la première borne du condensateur (30) et dont l'émetteur (E) est relié à la borne de commande (GP1) du composant semi-conducteur (P1) et dont la borne de commande (B) est reliée à la seconde borne principale du premier transistor PMOS (M1) et par une première résistance (M6) au point de liaison entre la charge (20) et le composant semi-conducteur (P1),
- la première résistance (M6) comprend un second transistor NMOS (M6) dont la première borne principale (DM6) est reliée à la base (B) du transistor bipolaire NPN (Q1) et la seconde borne principale (SM6) est reliée à la seconde borne principale (SP1) du composant semi-conducteur (P1), sa borne de commande (GM6) recevant le signal de commande inversé ($\overline{ST}$).

2. Circuit de commande selon la revendication 1, **caractérisé par** un circuit de pompage de charge (40) recevant le signal de commande (ST) et fournissant un signal de commande relevé (ST) appliqué à la borne de commande (GP1) du composant semi-conducteur (P1).

3. Circuit de commande selon l'une quelconque des revendications 1 et 2, **caractérisé en ce que** le composant semi-conducteur (P1) est un transistor de puissance NMOS.

4. Circuit de commande selon l'une quelconque des revendications précédentes, **caractérisé en ce qu'** entre la borne de commande (GP1) et la seconde borne principale (SP1) du composant semi-conducteur (P1) il est prévu un circuit de limitation de tension (ZD, M3) pour limiter la tension (Vgs) entre ces deux bornes.

5. Circuit de commande selon la revendication 4, **caractérisé en ce que** le circuit de limitation de tension (ZD, M3) comprend :

- une diode Zener (ZD) dont la cathode est reliée à la borne de commande (GP1) du composant semi-conducteur (P1) et
- un troisième transistor NMOS (M3), dont la première borne principale (DM3) est reliée à l'anode de la diode Zener (ZD) et la seconde borne principale (SM3) est reliée à la seconde borne principale (SP1) du composant semi-conducteur (P1), sa borne de commande (GM3) étant reliée à la première borne principale (DM3).

6. Circuit de commande selon la revendication 5, **caractérisé par** un circuit d'activation de la pompe de charge (60, 70, 80) pour activer la pompe de charge (40) en fonction de la tension (Vgs).

7. Circuit de commande selon la revendication 6, **caractérisé en ce que** le circuit d'activation de la pompe de charge (60, 70, 80) comprend :

- une installation de temporisation (60) pour recevoir et temporiser le signal de commande (ST),
- un inverseur à hystérésis (70) recevant et inversant le potentiel appliqué à la première borne de commande (GM3) du troisième transistor NMOS (M3) et
- une porte ET (80) pour recevoir les signaux de sortie de l'installation de temporisation (60) et de l'inverseur à hystérésis (70) pour émettre un signal de sortie combiné correspondant pour activer le circuit de la pompe de charge (40).

**8.** Circuit de commande selon l'une quelconque des revendications précédentes,
**caractérisé par**
un circuit de régulation de tension (R3, M4, R4, C4, M5 ; ZD, M3) pour saisir la tension (Vgs) entre la borne de commande (GP1) et la seconde borne principale (SP1) du composant semi-conducteur (P1) et réguler la commande de l'élément de commutation (Q1) en fonction de cette tension.

**9.** Circuit de commande selon la revendication 8,
**caractérisé en ce que**
le circuit de régulation de tension (R3, M4, R4, C4, M5, ZD, M3) comprend :

- une seconde résistance (R3) dont la première borne est reliée à la première borne du condensateur (30),
- un quatrième transistor NMOS (M4) dont la première borne principale (DM4) est reliée à la seconde borne de la seconde résistance (R3) et dont la seconde borne principale (SM4) est reliée à la seconde borne principale (SP1) du composant semi-conducteur (P1), sa borne de commande (GM4) étant reliée à la borne de commande (GM3) du troisième transistor NMOS (M3) et
- un second transistor PMOS (M5) dont la première borne principale (DM5) est reliée à la première borne du condensateur (30), sa seconde borne principale (SM5) est reliée à la borne de commande (GM1) du premier transistor PMOS (M1) et sa borne de commande (GM5) est reliée à la seconde borne de la seconde résistance (R3).

**10.** Circuit de commande selon la revendication 9,
**caractérisé par**
un montage en série formé d'une troisième résistance (R4) et d'un second condensateur (C4) pour stabiliser la régulation, ce montage étant prévu entre la seconde borne principale (SM5) du second transistor PMOS (M5) et la première borne principale (DM4) du quatrième transistor NMOS (M4).

FIG 1

FIG 2

EP 0 992 114 B1

13

# FIG3

VBB

GATE P1

N2 o

N1

110

160

n+

190

p

p

N2 o

$p^+$

$p^+$

$p^+$

p

$p^+$

$N^+$

200

170

180

Q1

150

140

M1

130

120

D1

$N^-$

$N^+$

100

EP 0 992 114 B1